Europäisches Patentamt

European Patent Office

Office européen des brevets

(11) Numéro de publication: **0 275 595 B1**

# FASCICULE DE BREVET EUROPEEN

(45) Date de publication de fascicule du brevet: **17.03.93**   (51) Int. Cl.⁵: **H01L 21/90**, H01L 21/31

(21) Numéro de dépôt: **87202546.5**

(22) Date de dépôt: **16.12.87**

(54) **Procédé de réalisation d'interconnexions et de croisements entre niveaux de métallisation d'un circuit intégré.**

(30) Priorité: **23.12.86 FR 8618048**

(43) Date de publication de la demande:
**27.07.88 Bulletin 88/30**

(45) Mention de la délivrance du brevet:
**17.03.93 Bulletin 93/11**

(84) Etats contractants désignés:
**DE FR GB IT NL**

(56) Documents cités:
**EP-A- 0 155 668**
**US-A- 4 545 852**
**US-A- 4 568 410**

**EXTENDED ABSTRACTS/THE ELECTROCHE-MICAL SOCIETY, SPRING MEETING, Washington, D.C., 2-7 mai 1976, pages 119-121, résumé no. 41,; W. KERN: "Chemmical etching of dielectrics"**

(73) Titulaire: **LABORATOIRES D'ELECTRONIOUE PHILIPS**
**3, Avenue Descartes**
**F-94450 Limeil-Brévannes(FR)**

(84) Etats contractants désignés:
**FR**

(73) Titulaire: **N.V. Philips' Gloeilampenfabrieken**
**Groenewoudseweg 1**
**NL-5621 BA Eindhoven(NL)**

(84) Etats contractants désignés:
**DE GB IT NL**

(72) Inventeur: **Rabinzohn, Patrick Société Civile S.P.I.D.**
**209, rue de l'Université**
**F-75007 Paris(FR)**

(74) Mandataire: **Landousy, Christian et al**
**Société Civile S.P.I.D. 156, Boulevard Haussmann**
**F-75008 Paris (FR)**

Rank Xerox (UK) Business Services
(3.10/3.5x/3.0.1)

## Description

L'invention concerne un procédé de réalisation d'interconnexions et de croisements entre niveaux de métallisation d'un circuit intégré.

Il est connu de l'état de la technique, par le brevet US-A-4 568 410, un procédé de gravure sèche sélective pour graver un nitrure en présence d'oxyde. Ce document décrit en particulier un procédé de fabrication de dispositifs semiconducteurs incluant la gravure préférentielle du nitrure de silicium par rapport à l'oxyde de silicium et comprenant les étapes où un substrat est muni d'une région d'oxyde de silicium recouverte d'une région de nitrure de silicium ; puis le dispositif est muni d'une couche de masquage munie de fenêtres exposant des zones prédéterminées de la région de nitrure de silicium ; le dispositif est alors placé dans une chambre à plasma dans laquelle est introduit un mélange de gaz incluant $O_2$ et $NF_3$ dans les rapports de 20-35 parties de $O_2$ pour 10-20 parties de $NF_3$ par volume, à une pression de l'ordre de 6,7 Pa, pour graver le nitrure de silicium exposé dans les fenêtres ; la gravure est continuée jusqu'à l'élimination des zones prédéterminées de nitrure de silicium, laissant exposé l'oxyde de silicium sous-jacent.

Il est par ailleurs connu de l'état de la technique par la demande de brevet EP-A-0 155 668 un procédé de planarisation par plasma. Le but du procédé est d'obtenir un dispositif totalement planaire. Selon ce procédé, une couche sacrifiée est réalisée sur un substrat préalablement muni d'une topographie de motifs de diverses épaisseurs. La couche sacrifiée a une vitesse de gravure supérieure à celle des motifs. Ainsi, lorsque le dispositif est soumis à l'action d'un plasma on peut éliminer la couche sacrifiée ainsi que des régions des motifs. En particulier on peut contrôler le taux de gravure de la couche sacrifiée vis-à-vis du taux de gravure des motifs en contrôlant le produit utilisé pour la gravure. On peut ainsi compenser les parties en relief de la couche sacrifiée et de certains motifs pour obtenir un dispositif dans lequel la topographie des motifs est complètement planaire.

La planarisation des topographies ayant des motifs de hauteurs différentes et variées est donc obtenue et cette planarisation se fait en une seule étape. La couche sacrifiée est de préférence une photorésist. En général le taux de gravure est entre 1,4 et 10 et ne dépend pas de la hauteur des motifs.

Les gaz utilisés pour réaliser la gravure par plasma sont $CHF_3/O_2$ sous une pression de 6,7 Pa avec un débit de 50 cc/mn. Différentes conditions de débit, pression et puissance sont possibles pour atteindre le but envisagé.

Un circuit intégré comme mentionné dans le préambule comprend un ensemble de composants reliés entre eux par des motifs de métallisation. Ces éléments consomment une part importante de la surface du circuit. Ainsi l'accroissement de la densité d'intégration passe par l'emploi de plusieurs niveaux métalliques (typiquement deux à trois) séparés par des couches de matériaux isolants et interconnectés selon un motif précis.

L'ensemble des opérations technologiques nécessaires à la réalisation de telles multicouches (conducteurs-isolants) doit permettre un rendement de fabrication élevé et une forte densité d'intégration. Cette dernière fait intervenir deux paramètres significatifs : le pas du motif de métallisation d'un niveau et l'encombrement de l'interconnexion entre deux niveaux. Le premier est fixé par la technique de définition du niveau métallique (gravure ou "lift-off"). Le second dépend de la technique d'interconnexion et apparaît limitatif selon l'état de l'art.

Deux techniques majeures d'interconnexion sont actuellement utilisées : la technique des trous et celle des piliers.

Le procédé de réalisation selon la technique des trous d'interconnexion fait intervenir trois photolithographies lors des étapes de la séquence technologique : la première pour la définition du premier niveau métallique, la deuxième pour la gravure des trous d'interconnexion et la troisième pour la définition du second niveau métallique.

Les contraintes imposées par cette technique sont les suivantes :

- Le profil du trou gravé dans le diélectrique doit être à pente contrôlée pour éviter les problèmes de couverture de marches (amincissement ou discontinuité du deuxième niveau). Une méthode adaptée de la technique des "espaceurs", peut être utilisée pour obtenir des profils "doux". La résolution de l'étape de gravure des trous est améliorée par l'emploi de la gravure ionique réactive (procédé anisotrope) et la mise en oeuvre de techniques spécifiques pour contrôler le profil.

- L'encombrement de l'interconnexion (niveau de masques emboîtés pour éviter les défauts de métallisation et d'alignement) prend en compte le biais du procédé de gravure et les tolérances de positionnement.

Le diélectrique couramment utilisé est de la silice. Les mêmes considérations s'appliquent à d'autres types d'isolants.

Dans la technique dite des piliers d'interconnexion, un pilier métallique est réalisé à l'endroit d'une interconnexion entre les deux niveaux de métallisation.

Le procédé de réalisation selon cette technique nécessite également trois photolithographies, la première lors de la définition du premier niveau métallique sous la forme d'une structure multicouche (conducteur-couche métallique d'arrêt de gravure-conducteur), la deuxième lors de la définition du pilier métallique au moyen d'une gravure jusqu'à la couche d'arrêt et la troisième lors de la définition du second niveau métallique après dépôt du diélectrique d'isolement entre niveaux et planarisation de ce diélectrique par l'emploi d'une couche sacrifiée jusqu'à déboucher sur les piliers.

Une variante de ce procédé est connue du brevet américain US-A-4 541 169. D'après ce document, la définition du premier niveau métallique est effectuée au moyen d'une couche métallique simple et la définition des piliers est obtenue par "lift-off".

La technique des piliers définis par gravure permet de diminuer l'encombrement de l'interconnexion : seules subsistent les tolérances de positionnement. Elle présente l'avantage de conduire à une structure plane composite métal-isolant et elle permet de plus un autoalignement partiel du pilier dans une direction sur le premier niveau. Mais la nécessité d'utiliser des plasmas chlorés pour la gravure du métal constitue un risque reconnu de contamination et de corrosion.

L'invention vise à réduire encore davantage l'encombrement de l'interconnexion afin d'obtenir une meilleure densité d'intégration. Dans le procédé proposé, aucune étape photolithographique spécifique n'est nécessaire à la réalisation des interconnexions entre niveaux de métallisation. Le quasi autoalignement des interconnexions constitue la différence fondamentale vis à vis des techniques couramment utilisées (gravure des trous au niveau des interconnexions, "lift-off" ou gravure des piliers métalliques) pour la réalisation de circuits intégrés à plusieurs niveaux de métallisation.

C'est pourquoi l'invention propose un procédé de réalisation d'interconnexions et de croisements entre niveaux de métallisation d'un circuit intégré, lesdites interconnexions entre deux niveaux de métallisation étant réalisées avec inversion de relief assurant l'autoalignement au niveau de chaque interconnexion, ladite inversion de relief étant obtenue par dépôt isotrope, planarisation au moyen d'une couche sacrifiée et gravure anisotrope et sélective par rapport à ladite couche sacrifiée selon la séquence des étapes suivantes :

a - réalisation d'un premier niveau de métallisation d'épaisseur $e_{m1}$ sur un substrat au moyen des techniques de gravure ou de "lift-off",

b - dépôt d'une première couche isolante d'épaisseur $e_{i1}$ constituant l'isolement entre ledit premier niveau de métallisation et le niveau de métallisation immédiatement supérieur à réaliser,

c - dépôt d'une deuxième couche isolante d'épaisseur $e_{i2}$,

d - gravure du motif d'isolement de ladite deuxième couche isolante, sélectivement vis à vis de la première couche, les parties restantes de la deuxième couche isolante constituant un masque qui assure l'isolement par ladite première couche isolante aux niveaux des croisements des métallisations,

e - planarisation de la structure ainsi obtenue par emploi d'une couche sacrifiée,

f - gravure de ladite couche sacrifiée jusqu'au niveau de la deuxième couche isolante,

g - gravure de la structure ainsi obtenue, les vitesses de gravures respectives $R_1$, $R_2$ et $R_S$ desdites première couche, deuxième couche et couche sacrifiée et les relations entre les diverses épaisseurs métalliques et d'isolement étant telles que la gravure débouche sur le premier niveau de métallisation, en même temps que ladite deuxième couche isolante d'épaisseur $e_{i2}$ est partiellement ou entièrement gravée sur la surface de ladite structure, le relief dudit premier niveau de métallisation et l'inversion de relief aux emplacements des interconnexions résultant d'une gravure sélective première couche isolante/couche sacrifiée, assurant l'autoalignement de la gravure de ladite première couche isolante sur le premier niveau de métallisation sans étape photolithographique spécifique,

h - réalisation dudit niveau de métallisation immédiatement supérieur,

i - répétition des étapes de b à h pour chacun des niveaux de métallisation suivants.

Si ledit premier niveau de métallisation comporte des éléments d'épaisseurs différentes, $e_{m1}$ et $e'_{m1}$ telles que $e'_{m1} < e_{m1}$, à interconnecter simultanément au second niveau de métallisation, ladite séquence comporte à la suite de l'étape g les étapes supplémentaires suivantes, les étapes h et i restant inchangées :

g' - Dépôt d'une troisième couche isolante sur la structure en relief obtenue à l'issue de l'étape g pour laquelle le niveau de métallisation d'épaisseur $e_{m1}$ est atteint.

g" - Gravure du motif d'isolement de ladite troisième couche sélectivement vis à vis de la première couche.

g'"- Gravure de la structure ainsi obtenue de sorte que les vitesses de gravure respectives $R_1$ et $R_3$ desdites première et troisième couches isolantes permettent de déboucher sur les éléments de métallisation de plus petite épaisseur $e'_{m1}$ en même temps que l'épaisseur de la troisième couche isolante est entièrement gravée sur les surfaces planes de ladite structure et partiellement gravée avec une épaisseur croissant de haut en bas sur les parois des trous au-dessus des éléments métalliques de plus grande épaisseur $e_{m1}$ selon la technique dite des "espaceurs".

La première couche isolante peut être simple (silice par exemple) ou multicouches (nitrure de silicium/silice par exemple). Les dépôts de cette couche et des autres couches successives sont isotropes et formés entre autres par action chimique en phase vapeur (CVD ou PECVD).

La gravure sélective d'une couche isolante vis à vis d'une autre peut être obtenue au moyen d'une gravure ionique telle que RIE fluor-oxygène.

La couche sacrifiée est constituée par une résine ou un polyimide.

Une épaisseur $e_{i2}$ suffisante est choisie de façon à conserver une bicouche de diélectriques d'isolement entre ledit premier niveau de métallisation et le niveau de métallisation immédiatement supérieur, ce qui améliore la fiabilité et le rendement du circuit intégré.

La description suivante en regard des dessins annexés, le tout donné à titre d'exemple fera bien comprendre comment l'invention peut être réalisée.

La figure 1 définit les grandeurs d'encombrement relatives aux métallisations et interconnexions.

La figure 2 définit les paramètres associés à l'encombrement d'une interconnexion.

La figure 3 représente schématiquement la séquence technologique de la réalisation d'une interconnexion et d'un croisement entre deux niveaux métalliques d'un circuit intégré selon le procédé conforme à l'invention.

La figure 4 montre sur quelques motifs de métallisation la comparaison des capacités d'intégration selon l'art antérieur et selon le procédé de l'invention pour des interconnexions et croisements entre deux niveaux métalliques.

Les signes de référence correspondant à un même élément sont identiques sur les différentes figures.

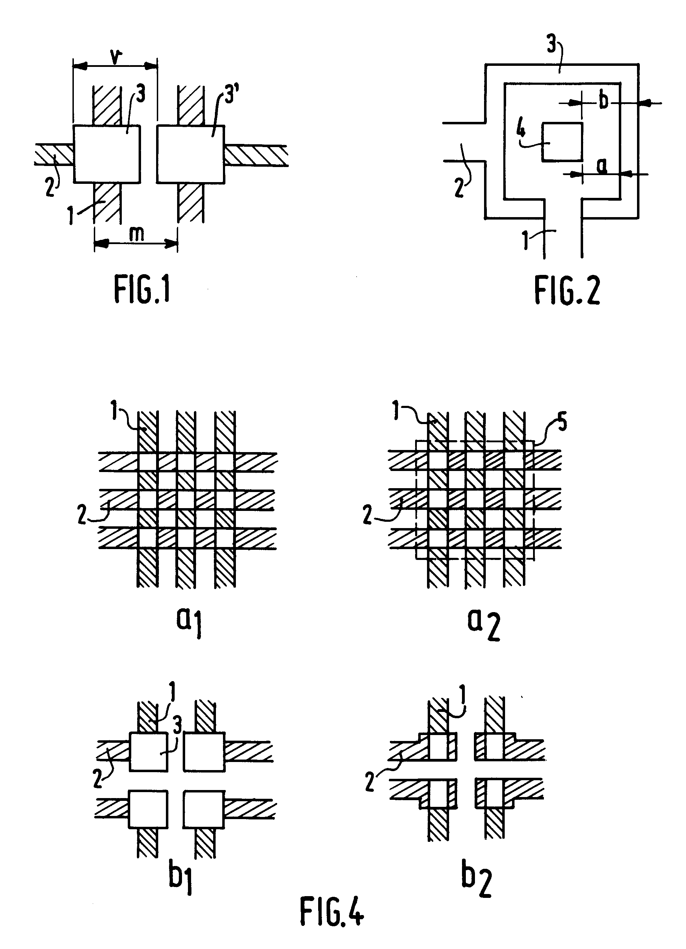

Sur la figure 1, on a représenté en vue de dessus et disposés côte à côte deux motifs d'interconnexion 3-3' entre les niveaux métalliques supérieur 2 et inférieur 1.

Le pas de métallisation d'un niveau est la distance m entre bords correspondants d'une bande métallique à l'autre.

L'encombrement de l'interconnexion est défini de la même façon par la distance v entre deux bords correspondants d'un motif au suivant.

La figure 2 montre par exemple une vue agrandie du motif d'interconnexion 3 représenté sur la figure précédente. L'encombrement de ce motif défini par les niveaux de masque emboîtés pour éviter les défauts de métallisation et d'alignement prend en compte le biais du procédé de gravure B et la tolérance de positionnement P. Sur la figure 2, a et b sont les distances respectives d'un bord du trou d'interconnexion 4 aux bords desdits masques. Dans la technique des trous on a les relations a = P et b = B + p.

Dans la technique des piliers définis par gravure qui permet un plus faible encombrement que la précédente, on a la relation a = b = p.

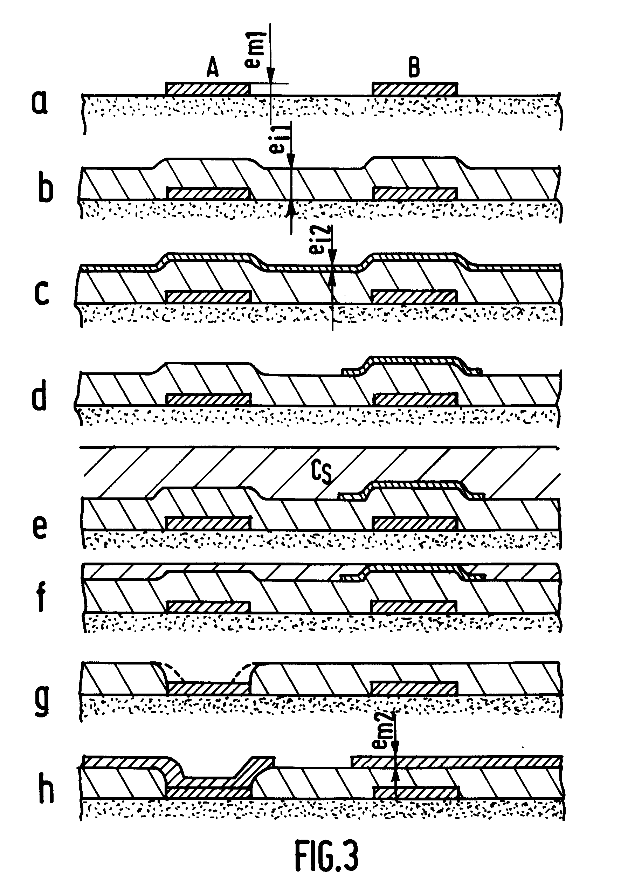

La séquence technologique du procédé de l'invention est représentée schématiquement sur la figure 3.

Lors d'une étape préliminaire schématisée en a, un premier niveau de métallisation a été obtenu sur un substrat au moyen d'une technique connue (gravure ou "lift-off"). Deux bandes contiguës de cette métallisation A et B d'épaisseur $e_{m1}$ sont vues en coupe transversale suivant le plan de la figure. On se propose de former entre ce premier niveau de métallisation et le niveau immédiatement supérieur, une interconnexion sur la bande A et un croisement au-dessus de la bande B, conformément au procédé de l'invention, en suivant l'ordre des étapes schématisées de b à h.

Etape b : dépôt d'une première couche isolante simple (silice) ou multicouches (nitrure de silicium/silice) d'épaisseur $e_{i1}$. Cette première couche constituera l'isolement entre métallisations.

Etape c : dépôt d'une deuxième couche isolante de plus faible épaisseur $e_{i2}$. Les dépôts ainsi formés sont isotropes et obtenus par action chimique en phase vapeur (CVD ou PECVD).

Etape d : définition lithographique d'un motif d'isolement et gravure sélective suivant ce motif, de la deuxième couche vis à vis de la première, les parties restantes de la deuxième couche isolante constituant un masque qui assure l'isolement par la première couche isolante au niveau des croisements des métallisations.

Etape e : planarisation de la structure ainsi obtenue par emploi d'une couche sacrifiée $C_S$ de résine ou polyimide.

Etape f : gravure de cette couche sacrifiée jusqu'à déboucher sur la deuxième couche isolante.

Etape g : gravure de la structure ainsi obtenue les vitesses de gravure respectives $R_1$, $R_2$, $R_S$ des couches isolantes d'épaisseurs $e_{i1}$ et $e_{i2}$ et de la couche sacrifiée et les relations entre ces diverses épaisseurs étant telles que la gravure débouche sur la bande métallique A en même temps que la couche isolante d'épaisseur $e_{i2}$ est partiellement ou entièrement gravée sur la surface plane au-dessus de la bande métallique B.

Les gravures ci-dessus sont effectuées par exemple selon une méthode ionique (RIE fluoroxygène).

Les conditions de gravure sont données par exemple par les relations suivantes entre les vitesses de gravure et les épaisseurs des diélectriques :

- Au niveau de l'interconnexion :

$$\frac{R_1}{R_S} > \frac{e_{i1}}{e_{m1}}$$

- Au niveau du croisement :

$$\frac{R_1}{R_2} - \frac{R_1}{R_S} > \frac{e_{i1} - e_{m1}}{e_{i2}}$$

Etape h : formation par une technique classique de la métallisation de niveau immédiatement supérieur, d'épaisseur $e_{m2}$, de façon à réaliser l'interconnexion et le croisement spécifié entre les deux niveaux.

Le caractère autoaligné de la gravure de la première couche d'isolement sur le premier niveau de métallisation provient du relief de celui-ci et de l'inversion dudit relief par gravure sélective. L'étape photolithographique se trouve ainsi éliminée.

Le remplacement de la définition des points d'interconnexion (trous ou piliers) par la définition de zones isolées permet un gain notoire en densité d'intégration. Ces zones peuvent en effet être regroupées et le motif résultant, bien moins critique, ne fixe pas de contraintes de dessin.

La figure 4 permet de comparer les capacités d'intégration selon l'art antérieur (en $a_1$ et $b_1$), et selon la technique quasi autoalignée de l'invention (en $a_2$ et $b_2$) pour des croisements (en $a_1$ et $a_2$) et des interconnexions (en $b_1$ et $b_2$) entre deux niveaux 1 et 2 représentés en vue de dessus. Sur le schéma $a_2$ de la figure, le masque "fantôme" d'isolement 5 est indiqué en pointillés.

Le pas des niveaux de métallisation m reste celui de l'art antérieur, c'est-à-dire m = 2 $\mu$m, soit un espacement de 1 $\mu$m entre bandes métalliques.

L'encombrement de l'interconnexion v est de 3 $\mu$m, soit par exemple, un trou de 1 $\mu$m, une tolérance de 0,5 $\mu$m et un espacement de 1 $\mu$m.

Il apparaît d'après la comparaison des schémas $b_1$ et $b_2$ de la figure 4 que le motif d'interconnexion réalisé selon le procédé de l'invention permet un gain de 20 % sur la surface occupée par le motif de l'art antérieur. Cette réduction de l'encombrement dépend du motif et des règles de dessin disponibles. Elle est, en particulier, d'autant plus importante que les tolérances d'alignement sont grandes. Le chiffre précédent constitue donc un minimum, compte tenu du choix de règles à la limite des possibilités actuelles pour l'exemple choisi.

La technique d'interconnexion selon l'invention permet donc d'augmenter la densité d'intégration. Par ailleurs, le diélectrique bicouche obtenu lorsque l'épaisseur de la deuxième couche $e_{i2}$ est suffisante, va dans le sens de l'amélioration du rendement et de la fiabilité.

Lorsque les épaisseurs de métallisations du premier niveau sont différentes, l'emploi de la technique des "espaceurs" (dépôt d'un diélectrique sur le relief obtenu à l'issue de l'étape technologique g, suivi de la gravure de ce diélectrique) conduit à la structure indiquée en pointillés sur le schéma g de la figure 3. Deux avantages importants en découlent : un meilleur contrôle du passage de marche et la possibilité de déboucher simultanément sur des motifs de premier niveau de métallisation situés à des altitudes différentes. L' "espaceur" peut être choisi tel qu'il soit juste gravé lors de la surgravure permettant de déboucher sur le motif d'altitude la plus basse.

## Revendications

1. Procédé de réalisation d'interconnexions et de croisements entre niveaux de métallisation d'un circuit intégré, lesdites interconnexions entre deux niveaux de métallisation étant réalisées avec inversion de relief assurant l'autoalignement au niveau de chaque interconnexion, ladite inversion de relief étant obtenue par dépôt isotrope, planarisation au moyen d'une couche sacrifiée et gravure anisotrope et sélective par rapport à ladite couche sacrifiée selon la séquence des étapes suivantes :

a - réalisation d'un premier niveau de métallisation d'épaisseur $e_{m1}$ sur un substrat au moyen des techniques de gravure ou de "lift-off",

b - dépôt d'une première couche isolante d'épaisseur $e_{i1}$ constituant l'isolement entre ledit premier niveau de métallisation et le niveau de métallisation immédiatement supérieur à réaliser,

c - dépôt d'une deuxième couche isolante d'épaisseur $e_{i2}$,

d - gravure du motif d'isolement de ladite deuxième couche isolante, sélectivement vis à vis de la première couche, les parties restantes de la deuxième couche isolante constituant un masque qui assure l'isolement par ladite première couche isolante aux niveaux des croisements des métallisations,

e - planarisation de la structure ainsi obtenue par emploi d'une couche sacrifiée,

f - gravure de ladite couche sacrifiée jusqu'au niveau de la deuxième couche isolante,

g - gravure de la structure ainsi obtenue, les vitesses de gravures respectives $R_1$, $R_2$ et $R_S$ desdites première couche, deuxième couche et couche sacrifiée et les relations entre les diverses épaisseurs métalliques et d'isolement étant telles que la gravure débouche sur le premier niveau de métallisation, en même temps que ladite deuxième couche isolante d'épaisseur $e_{i2}$ est partiellement ou entièrement gravée sur la surface de ladite structure, le relief dudit premier niveau de métallisation et l'inversion de relief aux emplacements des interconnexions résultant d'une gravure sélective première couche isolante/couche sacrifiée, assurant l'autoalignement de la gravure de ladite première couche isolante sur le premier niveau de métallisation sans étape photolithographique spécifique,

h - réalisation dudit niveau de métallisation immédiatement supérieur,

i - répétition des étapes de b à h pour chacun des niveaux de métallisation suivants.

2. Procédé selon la revendication 1, dans lequel ledit premier niveau de métallisation comporte des éléments d'épaisseurs différentes $e_{m1}$ et $e'_{m1}$ telles que $e'_{m1} < e_{m1}$, caractérisé en ce qu'il comporte à la suite de l'étape technologique g, les étapes supplémentaires suivantes, les étapes h et i restant inchangées :

g' - dépôt d'une troisième couche isolante sur la structure en relief obtenue à l'issue de l'étape g pour laquelle le niveau de métallisation d'épaisseur $e_{m1}$ est atteint,

g" - gravure suivant un motif d'isolement, de ladite troisième couche sélectivement vis à vis de la première couche,

g'''- gravure de la structure ainsi obtenue de sorte que les vitesses de gravure respectives $R_1$ et $R_3$ desdites première et troisième couches isolantes permettent de déboucher sur les éléments de métallisation de plus petite épaisseur $e'_{m1}$ en même temps que l'épaisseur de la troisième couche isolante est entièrement gravée sur les surfaces planes de ladite structure et partiellement gravée avec une épaisseur croissant de haut en bas sur les parois des trous au-dessus des éléments métalliques de plus grande épaisseur $e_{m1}$ selon la technique dite des "espaceurs".

3. Procédé selon l'une des revendications 1 ou 2, caractérisé en ce que ladite première couche isolante peut être une couche simple, en silice par exemple, ou multicouches, en nitrure de silicium/silice par exemple.

4. Procédé selon l'une des revendications 1 ou 2, caractérisé en ce que lesdits dépôts de couches isolantes sont isotropes et obtenus par action chimique en phase vapeur CVD ou PECVD.

5. Procédé selon l'une des revendications 1 ou 2, caractérisé en ce que la gravure sélective d'une couche isolante vis à vis d'une autre est obtenue au moyen d'une gravure ionique telle que RIE fluor-oxygène.

6. Procédé selon l'une des revendications 1 ou 2, caractérisé en ce que ladite couche sacrifiée est constituée par une résine ou un polyimide.

7. Procédé selon l'une des revendications 1 ou 2, caractérisé en ce qu'une une épaisseur $e_{i2}$ suffisante est choisie de façon à conserver une bicouche de diélectriques d'isolement entre ledit premier niveau de métallisation et le niveau de métallisation immédiatement supérieur.

**Claims**

1. A process for producing interconnecting lines and crossings between metallization levels of an integrated circuit, characterized in that the said interconnecting lines between two metallization levels are realized with an inversion of relief ensuring self-alignment at the level of each interconnection, which inversion of relief is obtained by isotropic deposition, planarization by means of a sacrificial layer, and anisotropic and selective etching relative to the said sacrificial layer in accordance with the following sequence of steps:

a. realisation of a first metallization level with a thickness $e_{m1}$ on a substrate by means of etching or "lift-off" techniques,

b. deposition of a first insulating layer having a thickness $e_{i1}$ constituting the insulation between the said first metallization level and the metallization level to be realized immediately above it,

c. deposition of a second insulating layer having a thickness $e_{i2}$,

d. etching of the insulation pattern of the said second insulating layer selectively with respect to the first layer, whereby the remaining portions of the second insulating layer form a mask which ensures the insulation by the said first insulating layer at the level of the crossings of the metallizations,

e. planarization of the structure thus obtained by the use of a sacrificial layer,

f. etching of the said sacrificial layer down to the level of the second insulating layer,

g. etching of the structure thus obtained so that the respective etching rates $R_1$, $R_2$ and $R_S$ of the said first, second and sacrificial layers and the relations between the various metal and insulation thicknesses are such that etching ends at the first metallization level, while at the same time the said second insulating layer having a thickness $e_{i2}$ is partly or entirely etched on the surface of the said structure, the relief of the said first metallization level and the inversion of a relief at the areas of the interconnections resulting from a selective etching of the first insulating layer with respect to the sacrificial layer, which ensures the self-alignment of the etching of the said first insulating layer at the first metallization level without any specific photolithographic step,

h. formation of the said metallization level lying immediately above,

i. repetition of the steps b to h for each subsequent metallization level.

2. A process as claimed in Claim 1, in which the said first metallization level comprises elements of different thicknesses $e_{m1}$ and $e'_{m1}$ with $e'_{m1} < e_{m1}$, characterized in that it comprises after the technological step g the following supplementary steps, the steps h and i remaining unchanged:

g' deposition of a third insulating layer on the relief structure obtained at the end of the step g, for which the metallization level having a thickness $e_{m1}$ is reached,

g" etching according to a insulation pattern of the said third layer selectively with respect to the first layer,

g"' etching of the structure thus obtained so that the respective etching rates $R_1$ and $R_3$ of the said first ad third insulating layers permit of ending at the level of the metallization elements of smaller thickness $e_{m1}$, while at the same time the thickness of the third insulating layer is entirely etched on the flat surface of the said structure and is partly etched with a thickness increasing from top to bottom on the walls of the holes above the metal elements of greater thickness $e_{m1}$ by the spacers technique.

3. A process as claimed in any one of Claims 1 or 2, characterized in that the said first insulating layer may be a single layer, for example of silica, or a double layer, for example of silicon nitride/silica.

4. A process as claimed in any one of Claims 1 or 2, characterized in that the said depositions of insulating layers are isotropic and are obtained by chemical reaction from the vapour phase, CVD or PECVD.

5. A method as claimed in any one of Claims 1 or 2, characterized in that the selective etching of a insulating layer with respect to another such layer is obtained by means of ion etching, such as RIE with fluorine-oxygen.

6. A method as claimed in any one of Claims 1 or 2, characterized in that the said sacrificial layer is formed by a resin or a polyimide.

7. A process as claimed in any one of Claims 1 or 2, characterized in that the choice of a sufficient thickness $e_{i2}$ permits of maintaining a double layer of insulating dielectric materials between the said first metallization level ad the metallization level immediately above it.

**Patentansprüche**

1. Verfahren zum Herstellen von Verbindungen und Kreuzungen zwischen Metallisierungsebenen einer integrierten Schaltung, wobei diese Verbindungen zwischen zwei Metallisierungsebenen mit einer Umkehrung des Reliefs verwirklicht werden, wodurch Selbstausrichtung auf der Ebene jeder Verbindung gewährleistet ist, wobei diese Umkehrung des Reliefs erhalten wird durch isotropen Niederschlag, Planierung mittels einer Opferschicht und durch anisotropes und selektives Ätzen gegenüber der genannten Opferschicht entsprechend der nachfolgenden Folge von Verfahrensschritten:

a. Verwirklichung einer ersten Metallisierungsebene mit einer Dicke $e_{m1}$ auf einem Substrat durch Ätz- oder "Lift-Off"-Techniken,

b. Niederschlag einer ersten Isolierschicht mit einer Dicke $e_{i1}$, welche die Isolierung zwischen der genannten ersten Metallisierungsebene und der unmittelbar darüber zu verwirklichenden Metallisierungsebene bildet,

c. Niederschlag einer zweiten Isolierschicht mit einer Dicke $e_{i2}$,

d. Selektives Ätzen eines Isoliermusters der genannten zweiten Isolierschicht gegenüber der ersten Schicht, wodurch die restlichen Teile der zweiten Isolierschicht eine Maske bilden, welche die Isolierung durch die genannte erste Isolierschicht auf der Ebene der Kreuzungen der Metallisierungen gewährleistet,

e. Planierung der auf diese Weise erhaltenen Struktur durch Verwendung einer Opferschicht,

f. Ätzung der genannten Opferschicht bis an die Ebene der zweiten Isolierschicht,

g. Ätzung der auf diese Weise erhaltenen Struktur, so daß die betreffenden Ätzgeschwindigkeiten $R_1$, $R_2$ und $R_3$ der genannten ersten, zweiten Schicht bzw. der Opferschicht und die Beziehungen zwischen den jeweiligen Metall- und Isolationsdicken derart sind, daß das Ätzen aufhört bei der ersten Metallisierungsebene, während gleichzeitig die genannte zweite Isolierschicht mit einer Dicke $e_{i2}$ auf der Oberfläche der genannten Struktur teilweise oder völlig weggeätzt wird, wobei das Relief der genannten ersten Metallisierungsebene und die Umkehrung des Reliefs an den Stellen der Verbindungen das Ergebnis sind einer selektiven Ätzung der ersten Isolierschicht gegenüber der Opferschicht, wodurch die Selbstausrichtung der Ätzung der ersten Metallisierungsebene ohne einen spezifischen photolithographischen Verfahrensschritt gewährleistet ist,

h. Bildung der genannten Metallisierungsebene unmittelbar darüber,

i. Wiederholung der Schritte b bis h für jede nachfolgende Metallisierungsebene.

2. Verfahren nach Anspruch 1, wobei die genannte erste Metallisierungsebene Elemente unterschiedlicher Dicke aufweist, beispielsweise $e_{m1}$ und $e'_{m1}$ mit $e'_{m1} < e_{m1}$, die gleichzeitig auf der zweiten Metallisierungsebene miteinander verbunden werden müssen, weist die Folge nach dem Verfahrensschritt g die nachfolgenden zusätzlichen Verfahrensschritte auf, wobei die Schritte h und i ungeändert bleiben:

g' Niederschlag einer dritten Isolierschicht auf der am Ende des Verfahrensschrittes g erhaltenen Reliefstruktur, wozu die Metallisierungsebene mit einer Dicke $e_{m1}$ erreicht wird,

g" Ätzung des Isolationsmusters der genannten dritten Schicht, und zwar selektiv gegenüber der ersten Schicht,

g"' Ätzung der auf diese Weise erhaltenen Struktur, so daß die betreffenden Ätzgeschwindigkeiten $R_1$ und $R_3$ der genannten ersten und dritten Isolierschicht es erlauben, auf der Ebene der Metallisierungselemente mit einer geringeren Dicke $e_{m1}$ zu enden, während gleichzeitig die Dicke der dritten Isolierschicht auf den ebenen Flächen der genannten Struktur völlig geätzt ist und teilweise geätzt mit einer Dicke ansteigend von der Spitze bis zum Boden der Wände der Löcher über den Metallelementen mit einer größeren Dicke $e_{m1}$ durch Anwendung der sog. "Distanz-Technik".

3. Verfahren nach einem der Ansprüche 1 oder 2, dadurch gekennzeichnet, daß die genannte erste Isolierschicht eine einfache Schicht sein kann, beispielsweise aus Siliziumoxid, oder eine doppelte Schicht, beispielsweise aus Siliziumnitrid / Siliziumoxid.

4. Verfahren nach einem der Ansprüche 1 oder 2, dadurch gekennzeichnet, daß die genannten Niederschlägen der Isolierschichten Isotrop sind und durch chemische Reaktion aus der Dampfphase CVD oder PECVD erhalten werden.

5. Verfahren nach einem der Ansprüche 1 oder 2, dadurch gekennzeichnet, daß das selektive Ätzen einer Isolierschicht gegenüber einer anderen solchen Schicht durch Ionenätzen, wie RIE mit Fluor-Sauerstoff, durchgeführt worden ist.

6. Verfahren nach einem der Ansprüche 1 oder 2, dadurch gekennzeichnet, daß die genannte Opferschicht durch ein Harz oder ein Polyimid gebildet wird.

7. Verfahren nach einem der Ansprüche 1 oder 2, dadurch gekennzeichnet, daß eine ausreichende Dicke $e_{i2}$ gewählt wird, wodurch zwischen der genannten ersten Metallisierungsebene und der unmittelbar darüber liegenden Metallisierungsebene eine Doppelschicht aus isolierendem dielektrischem Material beibehalten wird.

FIG.1

FIG.2

$a_1$

$a_2$

$b_1$

$b_2$

FIG.4

FIG.3